# EUROPEAN PATENT APPLICATION

(11) **EP 4 848 966 A2**
(43) Date of publication of application: **02.12.2026**
(21) Application number: 26181898.3
(22) Date of filing: 29.05.2026
(51) Int. Cl.: H10P 72/00

(54) **SUBSTRATE PROCESSING APPARATUS AND SUBSTRATE PROCESSING METHOD**

(30) Priority: 30.05.2025 JP 2025090971
(71) Applicant: SCREEN Holdings Co., Ltd., Kyoto-shi, Kyoto 602-8585 (JP)
(72) Inventor: YAMANOUCHI, Yuta, Kyoto, 602-8585 (JP); KIKUCHI, Shunki, Kyoto, 602-8585 (JP); AOKI, Rikuta, Kyoto, 602-8585 (JP); ENDO, Toru, Kyoto, 602-8585 (JP); OKADA, Masashi, Kyoto, 602-8585 (JP); SHIMOKADO, Naoki, Kyoto, 602-8585 (JP); ODANI, Kaito, Kyoto, 602-8585 (JP); NAGATA, Hirofumi, Kyoto, 602-8585 (JP); NISHIDE, Hajime, Kyoto, 602-8585 (JP); YOSHIDA, Hiroshi, Kyoto, 602-8585 (JP); YAMAMURA, Mioto, Kyoto, 602-8585 (JP)
(74) Representative: Kilian Kilian & Partner mbB

(57) **Abstract**

An ambient-temperature liquid supplier supplies an ambient-temperature liquid a temperature of which is adjusted to a first temperature. A cooling liquid supplier supplies a cooling liquid a temperature of which is adjusted to a second temperature lower than the first temperature. A heating liquid supplier supplies a heading liquid a temperature of which is adjusted to a third temperature higher than the first temperature. A switcher selectively leads out the ambient-temperature liquid supplied by the ambient-temperature liquid supplier or the cooling liquid supplied by the cooling liquid supplier. The switcher selectively leads out the ambient-temperature liquid supplied by the ambient-temperature liquid supplier or the heating liquid supplied by the heating liquid supplier. The mixer mixes the liquid led out by the switcher and the liquid led out by the switcher, and leads out a mixed liquid.

## Description

### BACKGROUND

### Technical Field

The present disclosure relates to a substrate processing apparatus that processes a substrate, and a substrate processing method of processing the substrate.

### Description of Related Art

A substrate processing apparatus is used to execute various processing on a substrate such as a semiconductor substrate, a substrate for a flat panel display (FPD) that is used for a liquid crystal display device, an organic electroluminescence (EL) display device, or the like, a substrate for an optical disc, a substrate for a magnetic disc, a substrate for a magneto-optical disc, a substrate for a photomask, a ceramic substrate or a substrate for a solar cell. For example, in a substrate processing apparatus described in JP 2016-15395 A, an etching liquid is prepared as a processing liquid by mixing a chemical liquid and pure water at a predetermined flow rate ratio using a mixer. The prepared processing liquid is discharged onto an upper surface of a substrate held and rotated by a spin chuck, whereby the upper surface of the substrate is etched.

### SUMMARY

In recent years, it has been desired to dynamically change, according to the progress of substrate processing, a temperature of a processing liquid discharged onto a substrate during the processing. Therefore, it is necessary to develop an apparatus capable of rapidly changing the temperature of the processing liquid over a wide range. In the substrate processing apparatus disclosed in JP 2016-15395 A, a temperature of pure water mixed with the chemical liquid is heated by a heater, so that the processing liquid is controlled to have a predetermined temperature. However, with this method, the temperature of the processing liquid cannot rapidly change over a wide range.

An object of the present disclosure is to provide a substrate processing apparatus and a substrate processing method that enable a temperature of a processing liquid to rapidly change over a wide range.

A substrate processing apparatus according to one aspect of the present disclosure includes a first liquid supplier that supplies a first liquid a temperature of which is adjusted to a first temperature, a second liquid supplier that supplies the first liquid the temperature of which is adjusted to a second temperature lower than the first temperature, a third liquid supplier that supplies the first liquid the temperature of which is adjusted to a third temperature higher than the first temperature, a first switcher that selectively leads out the first liquid supplied by the first liquid supplier or the first liquid supplied by the second liquid supplier, a second switcher that selectively leads out the first liquid supplied by the first liquid supplier or the first liquid supplied by the third liquid supplier, a first mixer that mixes the first liquid led out by the first switcher and the first liquid led out by the second switcher, and leads out a mixed liquid, and a first processing nozzle that discharges, onto one surface of a substrate, a processing liquid including the first liquid led out by the first mixer.

A substrate processing method according to another aspect of the present disclosure includes supplying, using a first liquid supplier, a first liquid a temperature of which is adjusted to a first temperature, supplying, using a second liquid supplier, the first liquid the temperature of which is adjusted to a second temperature lower than the first temperature, supplying, using a third liquid supplier, the first liquid the temperature of which is adjusted to a third temperature higher than the first temperature, selectively leading out, using a first switcher, the first liquid supplied by the first liquid supplier or the first liquid supplied by the second liquid supplier, selectively leading out, using a second switcher, the first liquid supplied by the first liquid supplier or the first liquid supplied by the third liquid supplier, mixing the first liquid led out by the first switcher and the first liquid led out by the second switcher, and leading out a mixed liquid, and discharging, using a first processing nozzle, a processing liquid including the first liquid led out by the first mixer onto one surface of a substrate.

With the present disclosure, the temperature of the processing liquid can rapidly change over a wide range.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a diagram showing the configuration of a substrate processing apparatus according to one embodiment of the present disclosure;
Fig. 2 is a diagram showing the configuration of a liquid supplier;
Fig. 3 is a diagram showing the configuration of the liquid supplier;
Fig. 4 is a diagram showing the configuration of a fluid box;
Fig. 5 is a diagram for explaining generation of a processing liquid;
Fig. 6 is a diagram showing the configuration of a processing chamber;
Fig. 7 is a diagram showing the configuration of a control device;
Fig. 8 is a diagram showing functions of the control device of Fig. 7; and
Fig. 9 is a flowchart showing one example of substrate processing executed in the substrate processing apparatus.

### DETAILED DESCRIPTION

### 1. Substrate Processing Apparatus

A substrate processing apparatus and a substrate processing method according to one embodiment of the present disclosure will be described below with reference to the drawings. In the following description, a substrate refers to a substrate for a flat panel display (FPD) that is used for a liquid crystal display device, an organic electroluminescence (EL) display device, or the like, a semiconductor substrate, a substrate for an optical disc, a substrate for a magnetic disc, a substrate for a magneto-optical disc, a substrate for a photomask, a ceramic substrate, a substrate for a solar cell, or the like. Further, the substrate has a circular shape except for a notch.

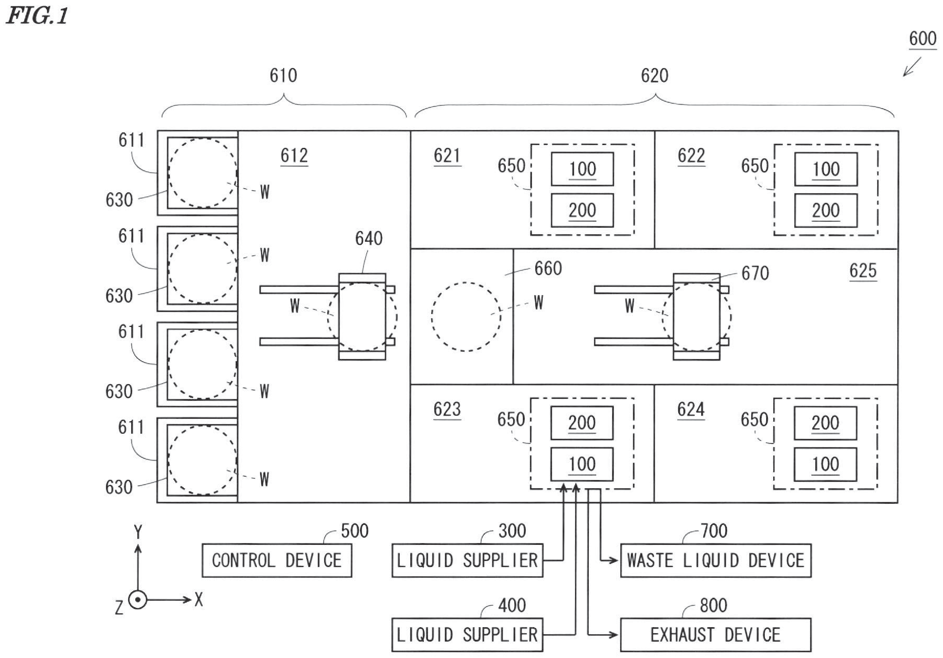

Fig. 1 is a diagram showing the configuration of the substrate processing apparatus according to one embodiment of the present disclosure. Fig. 1 is accompanied by arrows that indicate X, Y, and Z directions orthogonal to one another for the clarity of a positional relationship. The X and Y directions are orthogonal to each other within a horizontal plane, and the Z direction corresponds to a vertical direction. As shown in Fig. 1, the substrate processing apparatus 600 includes an indexer block 610, a processing block 620, a plurality of carriers 630, a transport mechanism 640, a plurality of chambers 650, a receiver-transferer 660, and a transport mechanism 670. The substrate processing apparatus 600 also includes liquid suppliers 300, 400 and a control device 500. A waste liquid device 700 and an exhaust device 800 are provided in a factory where the substrate processing apparatus 600 is installed.

The indexer block 610 and the processing block 620 are arranged side by side in the X direction. The indexer block 610 includes a plurality of carrier platforms 611 (four carrier platforms 611 in the example of Fig. 1) and a transport chamber 612. The plurality of carrier platforms 611 are provided to be arranged in the Y direction in the end portion of the indexer block 610 in the X direction. The transport chamber 612 is provided to be in contact with the plurality of carrier platforms 611.

The plurality of carriers 630 are respectively provided in the plurality of carrier platforms 611. In each carrier 630, substrates W to be processed are stored in multiple stages. The transport mechanism 640 is provided in the transport chamber 612. The transport mechanism 640 is a transport robot having an arm, for example, and holds the substrate W using the arm, and transport the held substrate W.

The processing block 620 includes towers 621 to 624 and a transport chamber 625. Each of the towers 621 to 624 is a casing having an inner space extending in an upward-and-downward direction (Z direction). The towers 621, 622 are aligned in the X direction such that the tower 621 is disposed between the transport chamber 612 and the tower 622. The towers 623, 624 are aligned in the X direction such that the tower 623 is disposed between the transport chamber 612 and the tower 624. Thus, the tower 621 and the tower 623 are opposite to each other in the Y direction, and the tower 622 and the tower 624 are opposite to each other in the Y direction. The transport chamber 625 is provided between the towers 621, 622 and the towers 623, 624.

In each of the towers 621 to 624, a plurality of chambers 650 (three chambers 650 in the present example) are provided in a stack. That is, the twelve chambers 650 are provided in the substrate processing apparatus 600 in the present example. Each chamber 650 includes a fluid box 100 and a processing chamber 200. The fluid box 100 includes a pipe, a valve, and the like, and guides a processing liquid used for processing the substrate W to the processing chamber 200. The processing chamber 200 processes the substrate W using the processing liquid guided by the fluid box 100. In the chamber 650, the used processing liquid is discharged to the waste liquid device (drain) 700. Further, an atmosphere in the chamber 650 is exhausted to the exhaust device 800.

In the transport chamber 625, the receiver-transferer 660 is provided so as to be in contact with the transport chamber 612. Further, the transport mechanism 670 is provided in the transport chamber 625. The receiver-transferer 660 is a stage on which the substrate W is to be placed, for example. The substrate W to be transferred and received between the transport mechanism 640 in the transport chamber 612 and the transport mechanism 670 is temporarily placed on the receiver-transferer 660. The receiver-transferer 660 may be configured such that a plurality of substrates W are placed in multiple stages on the receiver-transferer 660. The transport mechanism 670 is a transport robot having an arm, for example, and holds the substrate W using the arm, and transports the held substrate W. The transport mechanism 670 may have a configuration similar to that of the transport mechanism 640.

The liquid supplier 300 supplies liquids maintained at a plurality of temperatures (three temperatures in the present example) to the fluid box 100 in each chamber 650. The liquid supplier 400 supplies various liquids to the fluid box 100 in each chamber 650. In the present example, the liquid supplied by the liquid supplier 300 is pure water (DIW), and the liquid supplied by the liquid supplier 400 is a chemical liquid. The pure water and the chemical liquid are used to generate the processing liquid. The control device 500 controls the operation of each component of the substrate processing apparatus 600 according to a processing recipe describing the contents of substrate processing.

While the liquid suppliers 300, 400 and the control device 500 are provided outside of the indexer block 610 and the processing block 620 in the example of Fig. 1, the embodiment is not limited to this. Part or all of the liquid suppliers 300, 400 and the control device 500 may be provided inside of the indexer block 610, the processing block 620, or another block (not shown) of the substrate processing apparatus 600. The other block may be an interface block disposed to be adjacent to the processing block 620. Alternatively, the other block may be a lower block below the installation level of the indexer block 610 and the processing block 620.

An operation of the substrate processing apparatus 600 will be described. The carrier 630 in which unprocessed substrates W are accommodated is placed on the carrier platform 611 of the indexer block 610. The transport mechanism 640 in the transport chamber 612 transports an unprocessed substrate W from the carrier 630 to the receiver-transferer 660 in the processing block 620. Further, the transport mechanism 640 transports a processed substrate W placed on the receiver-transferer 660 to the carrier 630.

The transport mechanism 670 in the transport chamber 625 transports the unprocessed substrate W placed on the receiver-transferer 660 to any one of the processing chambers 200 provided in the towers 621 to 624 in the processing block 620. The substrate W that is transported to the processing chamber 200 is processed using the processing liquid. Further, the transport mechanism 670 transports the processed substrate W from each processing chamber 200 to the receiver-transferer 660.

### 2. Liquid Suppliers

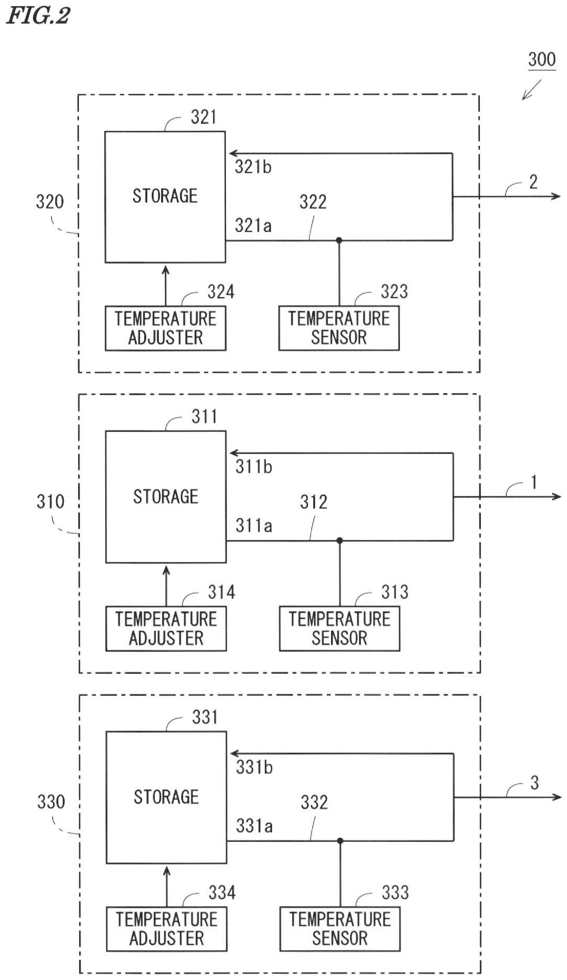

Fig. 2 is a diagram showing the configuration of the liquid supplier 300. As shown in Fig. 2, the liquid supplier 300 includes an ambient-temperature liquid supplier 310, a cooling liquid supplier 320, and a heating liquid supplier 330. The ambient-temperature liquid supplier 310 supplies, to the fluid box 100 of Fig. 1, a liquid the temperature of which is adjusted to be close to a first temperature. The cooling liquid supplier 320 supplies, to the fluid box 100, a liquid the temperature of which is adjusted to be close to a second temperature. The heating liquid supplier 330 supplies, to the fluid box 100, a liquid the temperature of which is adjusted to be close to a third temperature.

The first temperature is approximately room temperature, and is 23 °C in the present example. The second temperature is lower than the first temperature, and is 5 °C in the present example. The third temperature is higher than the first temperature, and is 80 °C in the present example. In the following description, the liquid supplied by the ambient-temperature liquid supplier 310 is referred to as an ambient-temperature liquid. The liquid supplied by the cooling liquid supplier 320 is referred to as a cooling liquid. The liquid supplied by the heating liquid supplier 330 is referred to as a heating liquid.

Specifically, the ambient-temperature liquid supplier 310 includes a storage 311, a circulation pipe 312, a temperature sensor 313, and a temperature adjuster 314. The storage 311 is a tank, for example, and stores the ambient-temperature liquid. The storage 311 has a lead-out port 311a and a lead-in port 311b. One end of the circulation pipe 312 is connected to the lead-out port 311a of the storage 311. The other end of the circulation pipe 312 is connected to the lead-in port 311b of the storage 311.

The ambient-temperature liquid stored in the storage 311 is led out from the lead-out port 311a through the circulation pipe 312. The ambient-temperature liquid flowing through the circulation pipe 312 is led into the storage 311 through the lead-in port 311b. In this manner, the circulation pipe 312 circulates the ambient-temperature liquid. Part of the circulation pipe 312 is accommodated in the fluid box 100 of Fig. 1, and part of the ambient-temperature liquid flowing through the circulation pipe 312 is supplied to a pipe 1, described below. The temperature sensor 313 is provided in the circulation pipe 312. The temperature sensor 313 detects a temperature of the ambient-temperature liquid flowing through the circulation pipe 312, and provides a detection result to the control device 500 of Fig. 1.

The temperature adjuster 314 includes a Peltier element, for example. The temperature adjuster 314 may include another temperature adjusting element such as a heat exchanger. Based on the control by the control device 500, the temperature adjuster 314 adjusts the temperature of the ambient-temperature liquid stored in the storage 311 such that the temperature detected by the temperature sensor 313 becomes close to the first temperature. With this configuration, since the ambient-temperature liquid circulates through the circulation pipe 312, even in a case in which a temperature around the liquid supplier 300 (room temperature) varies, the temperature of the ambient-temperature liquid can be maintained at the first temperature with high accuracy.

The cooling liquid supplier 320 has the configuration similar to that of the ambient-temperature liquid supplier 310, and includes a storage 321, a circulation pipe 322, a temperature sensor 323, and a temperature adjuster 324. The storage 321 has a lead-out port 321a and a lead-in port 321b, and stores the cooling liquid. One end of the circulation pipe 322 is connected to the lead-out port 321a of the storage 321. The other end of the circulation pipe 322 is connected to the lead-in port 321b of the storage 321. The circulation pipe 322 circulates the cooling liquid stored in the storage 321 through the lead-out port 321a and the lead-in port 321b. Part of the circulation pipe 322 is accommodated in the fluid box 100, and part of the cooling liquid flowing through the circulation pipe 322 is supplied to a pipe 2, described below.

The temperature sensor 323 detects a temperature of the cooling liquid flowing through the circulation pipe 322, and provides a detection result to the control device 500. Based on the control by the control device 500, the temperature adjuster 324 adjusts the temperature of the cooling liquid stored in the storage 321 such that the temperature detected by the temperature sensor 323 becomes close to the second temperature. Thus, the temperature of the cooling liquid can be maintained at the second temperature with high accuracy. In the present example, the temperature adjuster 324 may include a chiller device.

The heating liquid supplier 330 has the configuration similar to that of the ambient-temperature liquid supplier 310, and includes a storage 331, a circulation pipe 332, a temperature sensor 333, and a temperature adjuster 334. The storage 331 has a lead-out port 331a and a lead-in port 331b, and stores the heating liquid. One end of the circulation pipe 332 is connected to the lead-out port 331a of the storage 331. The other end of the circulation pipe 332 is connected to the lead-in port 331b of the storage 331. The circulation pipe 332 circulates the heating liquid stored in the storage 331 through the lead-out port 331a and the lead-in port 331b. Part of the circulation pipe 332 is accommodated in the fluid box 100, and part of the heating liquid flowing through the circulation pipe 332 is supplied to a pipe 3, described below.

The temperature sensor 333 detects a temperature of the heating liquid flowing through the circulation pipe 332, and provides a detection result to the control device 500. Based on the control by the control device 500, the temperature adjuster 334 adjusts the temperature of the heating liquid stored in the storage 331 such that the temperature detected by the temperature sensor 333 becomes close to the third temperature. Thus, the temperature of the heating liquid can be maintained at the third temperature with high accuracy. In the present example, the temperature adjuster 334 may include a heater.

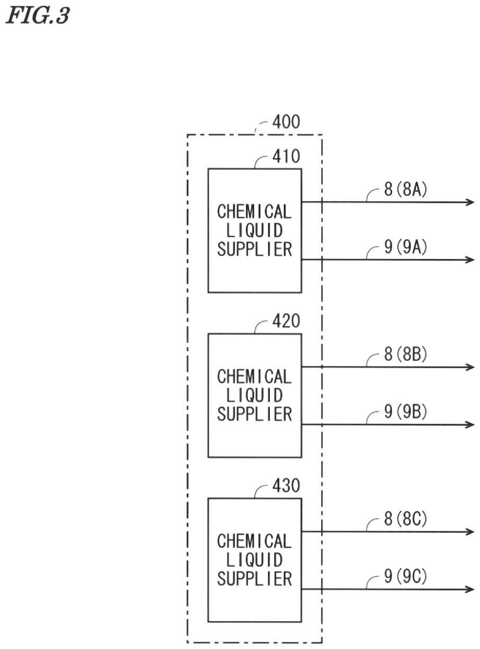

Fig. 3 is a diagram showing the configuration of the liquid supplier 400. As shown in Fig. 3, the liquid supplier 400 includes chemical liquid suppliers 410, 420, 430. The chemical liquid suppliers 410, 420, 430 supply a first chemical liquid, a second chemical liquid, and a third chemical liquid to the fluid box 100, respectively. In the present example, the first chemical liquid, the second chemical liquid, and the third chemical liquid are a hydrogen peroxide solution, ammonia water, and hydrochloric acid, respectively.

Specifically, the chemical liquid supplier 410 supplies the hydrogen peroxide solution to the fluid box 100 through each of a pipe 8 (pipe 8A) and a pipe 9 (pipe 9A), described below. The chemical liquid supplier 420 supplies the ammonia water to the fluid box 100 through each of a pipe 8 (pipe 8B) and a pipe 9 (pipe 9B), described below. The chemical liquid supplier 430 supplies the hydrochloric acid to the fluid box 100 through each of a pipe 8 (pipe 8C) and a pipe 9 (pipe 9C), described below.

### 3. Configuration of Fluid Boxes

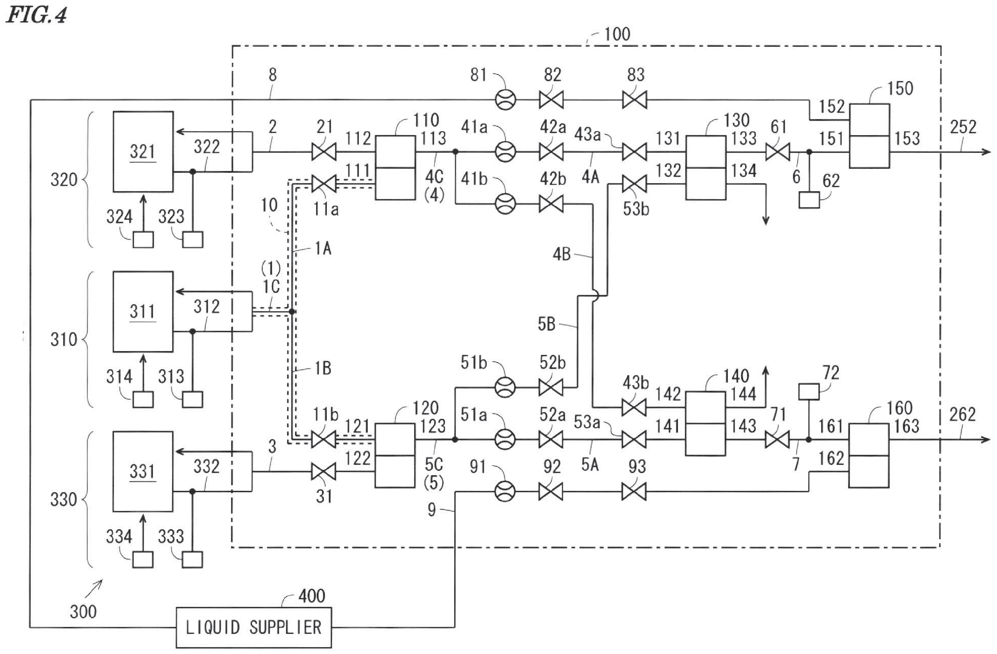

Fig. 4 is a diagram showing the configuration of the fluid box 100. As shown in Fig. 4, the fluid box 100 includes a plurality of pipes 1 to 9, and also includes various open-close valves, a flow-rate sensor, a flow-rate adjustment valve, a temperature sensor, and the like. Although a plurality of pipes 8 and a plurality of pipes 9 are provided in the present example, only one pipe 8 and one pipe 9 are shown in Fig. 4. Further, the fluid box 100 includes switchers 110, 120 and mixers 130, 140, 150, 160. In the following description, a direction in which the liquid flows in each of the pipes 1 to 9 is defined as a downstream direction, and the direction opposite to the downstream direction is defined as an upstream direction.

The pipe 1 has an upstream pipe 1C, and two downstream pipes 1A, 1B into which the upstream pipe 1C branches. Similarly, the pipe 4 has an upstream pipe 4C, and two downstream pipes 4A, 4B into which the upstream pipe 4C branches. The pipe 5 has an upstream pipe 5C, and two downstream pipes 5A, 5B into which the upstream pipe 5C branches. Each of the other pipes 2, 3, 6, 7, 8, 9 has one upstream end portion and the other downstream end portion. Further, in the present example, a thermal insulator 10 is wound around each of the pipes 1 to 5. In Fig. 4, only the thermal insulator 10 wound around the pipe 1 is indicated by the dotted line, and the thermal insulators 10 wound around the other pipes 2 to 5 are not shown.

The switchers 110, 120 are flow-path switching valves, for example. The switcher 110 has lead-in ports 111, 112 and a lead-out port 113. The switcher 110 selectively leads out, from the lead-out port 113, the liquid led in from the lead-in port 111 or the lead-in port 112. Similarly, the switcher 120 has lead-in ports 111, 112 and a lead-out port 123. The switcher 120 selectively leads out, from the lead-out port 123, the liquid led in from the lead-in port 121 or the lead-in port 122.

The mixer 130 has lead-in ports 131, 132 and lead-out ports 133, 134. The mixer 130 mixes the liquids led in from the lead-in port 131 and the lead-in port 132, and selectively leads out the mixed liquid from the lead-out port 133 or the lead-out port 134. The lead-out port 134 is connected to the waste liquid device 700 of Fig. 1. Similarly, the mixer 140 has lead-in ports 141, 142 and lead-out ports 143, 144. The mixer 140 mixes the liquids led in from the lead-in port 141 and the lead-in port 142, and selectively leads out the mixed liquid from the lead-out port 143 or the lead-out port 144. The lead-out port 144 is connected to the waste liquid device 700 of Fig. 1.

The mixer 150 has lead-in ports 151, 152 and a lead-out port 153. Although the mixer 150 has a plurality of lead-in ports 152 in the present example, only one lead-in port 152 is shown in Fig. 4. The plurality of lead-in ports 152 correspond to the plurality of pipes 8, respectively. The mixer 150 mixes the liquids led in from the lead-in port 151 and the plurality of lead-in ports 152, and leads out the mixed liquid from the lead-out port 153. The lead-out port 153 is connected to a pipe 252, described below, of the processing chamber 200 of Fig. 1.

Similarly, the mixer 160 has lead-in ports 161, 162 and a lead-out port 163. Although the mixer 160 has a plurality of lead-in ports 162 in the present example, only one lead-in port 162 is shown in Fig. 4. The plurality of lead-in ports 162 correspond to the plurality of pipes 9, respectively. The mixer 160 mixes the liquids led in from the lead-in port 161 and the plurality of lead-in ports 162, and leads out the mixed liquid from the lead-out port 163. The lead-out port 163 is connected to a pipe 262, described below, of the processing chamber 200.

The upstream pipe 1C of the pipe 1 is connected to the circulation pipe 312 of the ambient-temperature liquid supplier 310. The downstream pipes 1A, 1B of the pipe 1 are respectively connected to the lead-in port 111 of the switcher 110 and the lead-in port 121 of the switcher 120. An open-close valve 11a is provided in the downstream pipe 1A. An open-close valve 11b is provided in the downstream pipe 1B. The pipe 2 is connected between the circulation pipe 322 of the cooling liquid supplier 320 and the lead-in port 112 of the switcher 110. An open-close valve 21 is provided in the branch pipe 2. The pipe 3 is connected between the circulation pipe 332 of the heating liquid supplier 330 and the lead-in port 122 of the switcher 120. An open-close valve 31 is provided in the branch pipe 3.

The upstream pipe 4C of the pipe 4 is connected to the lead-out port 113 of the switcher 110. The downstream pipes 4A, 4B of the pipe 4 are respectively connected to the lead-in port 131 of the mixer 130 and the lead-in port 142 of the mixer 140. A flow-rate sensor 41a, a flow-rate adjustment valve 42a, and an open-close valve 43a are provided in the downstream pipe 4A. A flow-rate sensor 41b, a flow-rate adjustment valve 42b, and an open-close valve 43b are provided in the downstream pipe 4B.

The upstream pipe 5C of the pipe 5 is connected to the lead-out port 123 of the switcher 120. The downstream pipes 5A, 5B of the pipe 5 are respectively connected to the lead-in port 141 of the mixer 140 and the lead-in port 132 of the mixer 130. A flow-rate sensor 51a, a flow-rate adjustment valve 52a, and an open-close valve 53a are provided in the downstream pipe 5A. A flow-rate sensor 51b, a flow-rate adjustment valve 52b, and an open-close valve 53b are provided in the downstream pipe 5B.

The pipe 6 is connected between the lead-out port 133 of the mixer 130 and the lead-in port 151 of the mixer 150. An open-close valve 61 and a temperature sensor 62 are provided in the branch pipe 6. The pipe 7 is connected between the lead-out port 143 of the mixer 140 and the lead-in port 161 of the mixer 160. An open-close valve 71 and a temperature sensor 72 are provided in the branch pipe 7.

Each pipe 8 is connected between the liquid supplier 400 and the corresponding lead-in port 152 of the mixer 150. A flow-rate sensor 81, a flow-rate adjustment valve 82, and an open-close valve 83 are provided in each pipe 8. Each pipe 9 is connected between the liquid supplier 400 and the corresponding lead-in port 162 of the mixer 160. A flow-rate sensor 91, a flow-rate adjustment valve 92, and an open-close valve 93 are provided in each pipe 9.

Each of the open-close valves (11a, 11b, 21, 31, 43a, 43b, 53a, 53b, 61, 71, 83, 93) is switched between an open state and a close state based on the control by the control device 500 of Fig. 1. Each of the flow-rate sensors (41a, 41b, 51a, 51b, 81, 91) detects a flow rate of the liquid flowing through the pipe in which the flow-rate adjustment valve is provided, and provides a detection result to the control device 500.

Each of the flow-rate adjustment valves (42a, 42b, 52a, 52b, 82, 92) is a motor needle valve, for example, and adjusts, based on the control by the control device 500, a flow rate of the liquid flowing through the pipe in which the flow-rate adjustment valve is provided. Each of the temperature sensors (62, 72) detects a temperature of the liquid flowing through the pipe in which the temperature sensor is provided, and provides a detection result to the control device 500.

### 4. Operation of Fluid Boxes

In each of the mixers 130,140, a liquid having a temperature equal to or higher than the second temperature, and equal to or lower than the third temperature can be generated using the ambient-temperature liquid, the cooling liquid, and the heating liquid supplied from the liquid supplier 300. The liquids generated by the mixers 130, 140 are respectively led out from the pipes 6, 7 through the lead-out ports 133, 143 as base liquids for generating the processing liquid. The temperature sensors 62, 72 are used to check the temperature of the base liquid.

The control device 500 controls the operation of each component of the fluid box 100 such that the temperature of the base liquid dynamically changes during the substrate processing. In the present example, the operation of each component of the fluid box 100 is controlled such that the temperature of the base liquid is high at a start point in time of the substrate processing and the temperature of the base liquid gradually decreases as the substrate processing proceeds. Here, the flow rate of the base liquid and the temperature of the base liquid at each point in time during the substrate processing are specified by the processing recipe. In the following description, the temperature of the base liquid specified by the processing recipe is referred to as a specified temperature, and the flow rate of the base liquid specified by the processing recipe is referred to as a specified flow rate.

Specifically, in a period during which the specified temperature is the first temperature, the open-close valves 11a, 43a, 43b are in the open state, and the open-close valves 11b, 21, 31, 53a, 53b are in the close state, for example. In this case, the flow-rate adjustment valve 42a is controlled such that a flow rate detected by the flow-rate sensor 41 is the specified flow rate, and the flow-rate adjustment valve 42b is controlled such that a flow rate detected by the flow-rate sensor 41b is the specified flow rate. Thus, the ambient-temperature liquid at the specified temperature is supplied as the base liquid from each of the pipes 6, 7 at the specified flow rate.

Alternatively, in a period during which the specified temperature is the first temperature, the open-close valves 11b, 53a, 53b may be in the open state, and the open-close valves 11a, 21, 31, 43a, 43b may be in the close state. In this case, the flow-rate adjustment valve 52a is controlled such that a flow rate detected by the flow-rate sensor 51a is the specified flow rate, and the flow-rate adjustment valve 52b is controlled such that a flow rate detected by the flow-rate sensor 51b is the specified flow rate. Even in this case, the ambient-temperature liquid at the specified temperature is supplied as the base liquid from each of the pipes 6, 7 at the specified flow rate.

In a period during which the specified temperature is the second temperature, the open-close valves 21, 43a, 43b are in the open state, and the open-close valves 11a, 11b, 31, 53a, 53b are in the close state. Further, the flow-rate adjustment valve 42a is controlled such that a flow rate detected by the flow-rate sensor 41a is the specified flow rate, and the flow-rate adjustment valve 42b is controlled such that a flow rate detected by the flow-rate sensor 41b is the specified flow rate. Thus, the cooling liquid at the specified temperature is supplied as the base liquid from each of the pipes 6, 7 at the specified flow rate.

In a case in which the specified temperature is the third temperature, the open-close valves 31, 53a, 53b are in the open state, and the open-close valves 11a, 11b, 21, 43a, 43b are in the close state. Further, the flow-rate adjustment valve 52a is controlled such that a flow rate detected by the flow-rate sensor 51a is the specified flow rate, and the flow-rate adjustment valve 52b is controlled such that a flow rate detected by the flow-rate sensor 51b is the specified flow rate. Thus, the heating liquid at the specified temperature is supplied as the base liquid from each of the pipes 6, 7 at the specified flow rate.

In a case in which the specified temperature is higher than the second temperature and lower than the first temperature, the open-close valves 11b, 21, 43a, 43b, 53b are in the open state, and the open-close valves 11a, 31 are in the close state. Further, the flow-rate adjustment valve 42a is controlled such that a flow rate detected by the flow-rate sensor 41a is Fₐ of the following formula (1), and the flow-rate adjustment valve 52b is controlled such that a flow rate detected by the flow-rate sensor 51b is F₀ -Fₐ. Thus, the base liquid, in which the ambient-temperature liquid and the cooling liquid are mixed such that the base liquid is at the specified temperature, is supplied from the pipe 6 at the specified flow rate.

Similarly, the flow-rate adjustment valve 42b is controlled such that a flow rate detected by the flow-rate sensor 41b is Fₐ of the formula (1), and the flow-rate adjustment valve 52a is controlled such that a flow rate detected by the flow-rate sensor 51a is F₀ - Fₐ. Thus, the base liquid, in which the ambient-temperature liquid and the cooling liquid are mixed such that the base liquid is at the specified temperature, is supplied from the pipe 7 at the specified flow rate. Here, in the formula (1), F₀ is the specified flow rate, T₀ is the specified temperature, T₁ is the first temperature, and T₂ is the second temperature.
[Formula 1] ${F}_{a} = {F}_{0} ⋅ \frac{{T}_{1} - {T}_{0}}{{T}_{1} - {T}_{2}}$ (1)

In a case in which the specified temperature is higher than the first temperature and lower than the third temperature, the open-close valves 11a, 31, 43a, 53a, 53b are in the open state, and the open-close valves 11b, 21 are in the close state. Further, the flow-rate adjustment valve 52b is controlled such that a flow rate detected by the flow-rate sensor 51b is F_{b} of the following formula (2), and the flow-rate adjustment valve 42a is controlled such that a flow rate detected by the flow-rate sensor 41a is F₀ - F_{b}. Thus, the base liquid, in which the ambient-temperature liquid and the heating liquid are mixed such that the base liquid is at the specified temperature, is supplied from the pipe 6 at the specified flow rate.

Similarly, the flow-rate adjustment valve 52a is controlled such that a flow rate detected by the flow-rate sensor 51a is F_{b} of the following formula (2), and the flow-rate adjustment valve 42b is controlled such that a flow rate detected by the flow-rate sensor 41b is F₀ - F_{b}. Thus, the base liquid, in which the ambient-temperature liquid and the heating liquid are mixed such that the base liquid is at the specified temperature, is supplied from the pipe 7 at the specified flow rate. Here, in the formula (2), F₀ is the specified flow rate, T₀ is the specified temperature, T₁ is the first temperature, and T₃ is the third temperature.
[Formula 2] ${F}_{b} = {F}_{0} ⋅ \frac{{T}_{0} - {T}_{1}}{{T}_{3} - {T}_{1}}$ (2)

As described above, the base liquid the temperature of which changes is mixed with the chemical liquid in each of the mixers 150, 160, so that the processing liquid the temperature of which changes during the substrate processing is generated and supplied to the processing chamber 200 of Fig. 1. In the processing chamber 200, each time the substrate processing using the processing liquid ends, a certain amount of the base liquid is led out to the waste liquid device 700 from the lead-out port 134 of the mixer 130 and the lead-out port 144 of the mixer 140. With this configuration, even in a case in which a base liquid for previous substrate processing remains in a flow path, the base liquid is not mixed with a base liquid for subsequent substrate processing. This enables the temperature of the base liquid to accurately change according to the specified temperature described in the recipe.

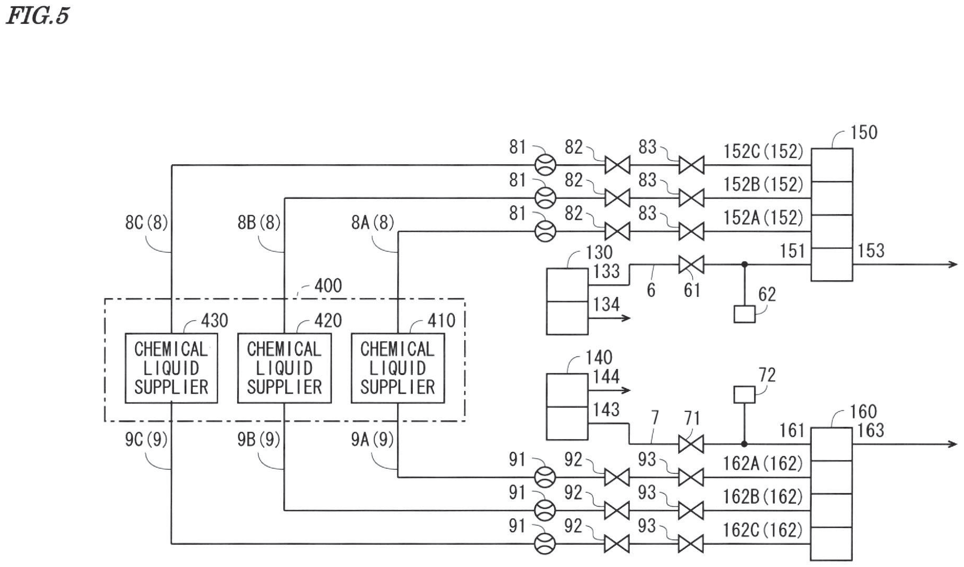

In the present example, in the mixers 150, 160, standard clean 1 (SC1) or standard clean 2 (SC2) can be selectively generated as the processing liquid. Fig. 5 is a diagram for explaining generation of the processing liquid. As shown in Fig. 5, the mixer 150 has the three lead-in ports 152, and the mixer 160 has the three lead-in ports 162. The three lead-in ports 152 are respectively referred to as lead-in ports 152A, 152B, 152C, and the three lead-in ports 162 are respectively referred to as lead-in ports 162A, 162B, 162C.

Further, in the fluid box 100, the three pipes 8 and the three pipes 9 are provided. The three pipes 8 are respectively referred to as pipes 8A, 8B, 8C, and the three pipes 9 are respectively referred to as pipes 9A, 9B, 9C. The chemical liquid supplier 410 is connected to the lead-in port 152A by the pipe 8A, and is connected to the lead-in port 162A by the pipe 9A. The chemical liquid supplier 420 is connected to the lead-in port 152B by the pipe 8B, and is connected to the lead-in port 162B by the pipe 9B. The chemical liquid supplier 430 is connected to the lead-in port 152C by the pipe 8C, and is connected to the lead-in port 162C by the pipe 9C.

In a case in which the SC1 is generated, the open-close valve 83 each of the pipes 8A, 8B, and the open-close valve 61 are in the open state, and the open-close valve 83 of the pipe 8C is in the close state. Further, based on detection results of the flow-rate sensors 81 of the pipes 8A, 8B, the flow-rate adjustment valves 82 of the pipes 8A, 8B are controlled. Thus, the ratio of the hydrogen peroxide solution led from the chemical liquid supplier 410 into the lead-in port 152A, to the ammonia water led from the chemical liquid supplier 420 into the lead-in port 152B, to the base liquid led from the lead-out port 133 of the mixer 130 into the lead-in port 151 is adjusted to a predetermined value. As a result, the SC1 is generated in the mixer 150.

Similarly, the open-close valve 93 of each of the pipes 9A, 9B, and the open-close valve 71 are in the open state, and the open-close valve 93 of the pipe 9C is in the close state. Further, based on detection results of the flow-rate sensors 91 of the pipes 9A, 9B, the flow-rate adjustment valves 92 of the pipes 9A, 9B are controlled. Thus, the ratio of the hydrogen peroxide solution led from the chemical liquid supplier 410 into the lead-in port 162A, to the ammonia water led from the chemical liquid supplier 420 into the lead-in port 162B, to the base liquid led from the lead-out port 143 of the mixer 140 into the lead-in port 161 is adjusted to a predetermined value. As a result, the SC1 is generated in the mixer 160.

In a case in which the SC2 is generated, the open-close valve 83 of each of the pipes 8A, 8C, and the open-close valve 61 are in the open state, and the open-close valve 83 of the pipe 8B is in the close state. Further, based on detection results of the flow-rate sensors 81 of the pipes 8A, 8C, the flow-rate adjustment valves 82 of the pipes 8A, 8C are controlled. Thus, the ratio of the hydrogen peroxide solution led from the chemical liquid supplier 410 into the lead-in port 152A, to the hydrochloric acid led from the chemical liquid supplier 430 into the lead-in port 152C, to the base liquid led from the lead-out port 133 of the mixer 130 into the lead-in port 151 is adjusted to a predetermined value. As a result, the SC2 is generated in the mixer 150.

Similarly, the open-close valve 93 of each of the pipes 9A, 9C, and the open-close valve 71 are in the open state, and the open-close valve 93 of the pipe 9B is in the close state. Further, based on detection results of the flow-rate sensors 91 of the pipes 9A, 9C, the flow-rate adjustment valves 92 of the pipes 9A, 9C are controlled. Thus, the ratio of the hydrogen peroxide solution led from the chemical liquid supplier 410 into the lead-in port 162A, to the hydrochloric acid led from the chemical liquid supplier 430 into the lead-in port 162C, to the base liquid led from the lead-out port 143 of the mixer 140 into the lead-in port 161 is adjusted to a predetermined value. As a result, the SC2 is generated in the mixer 160.

### 5. Processing Chambers

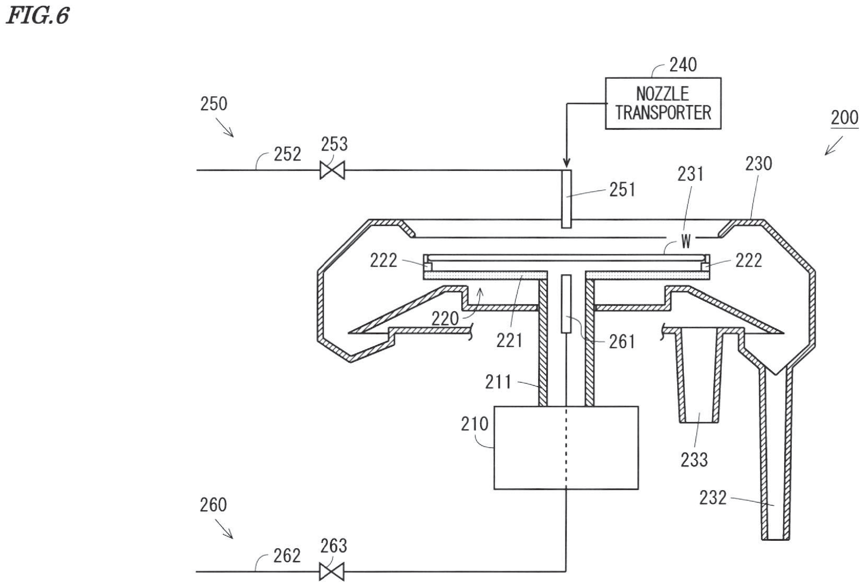

Fig. 6 is a diagram showing the configuration of the processing chamber 200. As shown in Fig. 6, the processing chamber 200 includes a spin motor 210, a substrate holder 220, a processing cup 230, a nozzle transporter 240, and processing liquid suppliers 250, 260. The spin motor 210 has a rotation shaft 211 extending upwardly. The substrate holder 220 is a spin chuck, for example, and includes a spin plate 221 and a plurality of chuck pins 222. The spin motor 210 is capable of rotating the rotation shaft 211 about a vertical axis.

The spin plate 221 has a disc shape, and is attached to an upper end portion of the rotation shaft 211 of the spin motor 210 in a substantially horizontal posture. Part of a processing nozzle 261 and part of a pipe 262, described below, of the processing liquid supplier 260 are inserted into the spin plate 221, the rotation shaft 211, and the spin motor 210. The plurality of chuck pins 222 are provided at substantially equal intervals in the peripheral portion of the spin plate 221 so as to project upwardly. The substrate W is held by the spin plate 221 in a substantially horizontal posture by the plurality of chuck pins 222 abutting against the outer peripheral end of the substrate W. The substrate W rotates about the vertical axis as the rotation shaft 211 of the spin motor 210 rotates in this state.

The processing cup 230 is provided to surround the substrate W held by the substrate holder 220, and receives the processing liquid splashing from the substrate W using its inner wall. An opening 231 is formed in an upper portion of the processing cup 230. The upper surface of the substrate W is exposed upwardly from the opening 231. This enables the upper surface of the substrate W to be processed from above. A waste liquid port 232 and an exhaust port 233 are formed in a lower portion of the processing cup 230. The waste liquid port 232 is connected to the waste liquid device 700 of Fig. 1, and discharges the processing liquid received by the inner wall of the processing cup 230 to the waste liquid device 700. The exhaust port 233 is connected to the exhaust device 800 of Fig. 1, and exhausts an atmosphere in the processing cup 230 to the exhaust device 800.

The nozzle transporter 240 is a transport arm, for example. When the substrate W is processed, the nozzle transporter 240 grips a processing nozzle 251, described below, of the processing liquid supplier 250, and transports the processing nozzle 251 to a processing position. When the substrate W is not processed, the nozzle transporter 240 grips the processing nozzle 251, and transports the processing nozzle 251 to a waiting position. The processing position is above the center of the substrate W. The waiting position is outward of the processing cup 230.

The processing liquid supplier 250 includes a processing nozzle 251, a pipe 252, and an open-close valve 253. The processing nozzle 251 has a discharge port through which the processing liquid can be discharged, and the discharge port is provided to be directed downwardly. The pipe 252 connects the lead-out port 153 of the mixer 150 of Fig. 4 to the processing nozzle 251. The open-close valve 253 is provided in the pipe 252, and is switched between an open state and a close state based on the control by the control device 500 of Fig. 1. The open-close valve 253 is switched to the open state when the processing nozzle 251 is at the processing position, whereby the processing nozzle 251 discharges the processing liquid led out from the lead-out port 153 through the pipe 252 to substantially the center of the upper surface of the rotating substrate W. Thus, the upper surface of the substrate W is processed.

The processing liquid supplier 260 includes the processing nozzle 261, the pipe 262, and an open-close valve 263. The processing nozzle 261 has a discharge port through which the processing liquid can be discharged, and the discharge port is provided to be directed upwardly. The pipe 262 connects the lead-out port 163 of the mixer 160 of Fig. 4 to the processing nozzle 261. The open-close valve 263 is provided in the pipe 262, and is switched between an open state and a close state based on the control by the control device 500 of Fig. 1. The open-close valve 263 is switched to the open state, whereby the processing nozzle 261 discharges the processing liquid led out from the lead-out port 163 through the pipe 262 to substantially the center of the lower surface of the rotating substrate W. Thus, the lower surface of the substrate W is processed.

### 6. Control Device

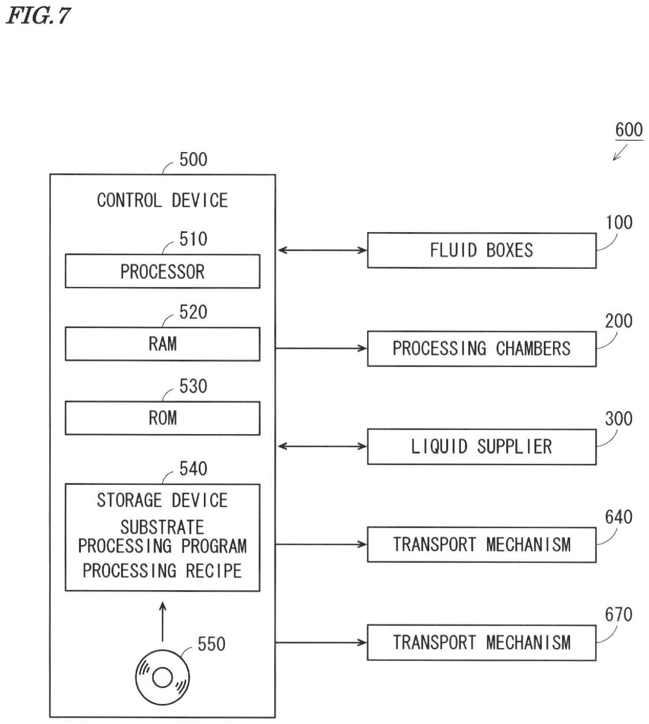

Fig. 7 is a diagram showing the configuration of the control device 500. As shown in Fig. 7, the control device 500 includes a processor 510, a random access memory (RAM) 520, a read only memory (ROM) 530, and a storage 540. The processor 510 includes a processor such as a central processing unit (CPU), a micro processing unit (MPU), a graphics processing unit (GPU), or a digital signal processor (DSP). The processor 510 may include a combination of two or more processors described above, or may include a field-programmable gate array (FPGA) or an application specific integrated circuit (ASIC).

The RAM 520 is used as a work area for the processor 510. A system program is stored in a ROM 530. The storage 540 includes a storage medium such as a hard disc or a semiconductor memory, and stores a substrate processing program for processing a substrate. Further, the storage 540 may store a plurality of processing recipes. In each processing recipe, the type of a processing liquid to be used for substrate processing, a change of temperature of the processing liquid during the substrate processing, the open state or the close state of each open-close valve for realizing the change of temperature, and a flow rate to be adjusted by each flow-rate adjustment valve are described.

The substrate processing program may be provided in the state of being stored in an external storage medium 550 such as a computer-readable SD memory card or a CD-ROM, and may be installed in the ROM 530 or the storage 540. Alternatively, the substrate processing program may be distributed from a server outside of the substrate processing apparatus 600 via a communication network to be installed in the ROM 530 or the storage 540. The processor 510 executes the substrate processing program to acquire detection results from various sensors, and controls the operations of the fluid boxes 100, the processing chambers 200, the liquid supplier 300, the transport mechanisms 640, 670, and the like. Thus, the substrate is processed.

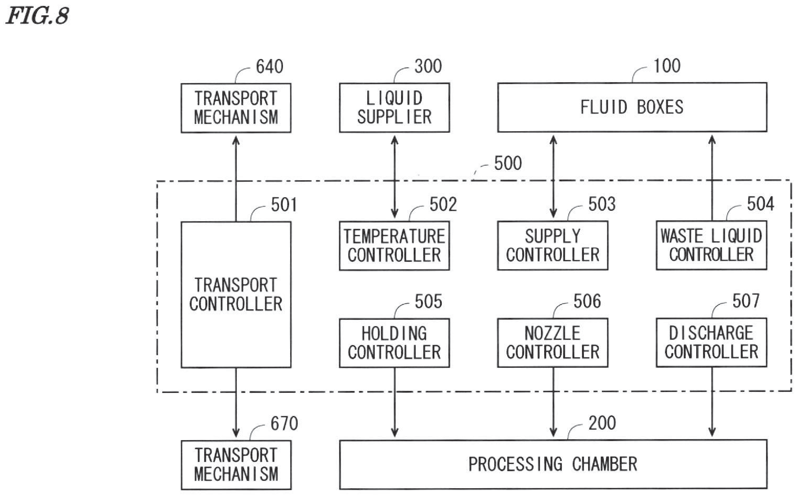

Fig. 8 is a diagram showing the functions of the control device 500 of Fig. 7. As shown in Fig. 8, the control device 500 includes, as functions, a transport controller 501, a temperature controller 502, a supply controller 503, a waste liquid controller 504, a holding controller 505, a nozzle controller 506, and a discharge controller 507. The functions of the control device 500 are implemented by execution of the substrate processing program by the processor 510. Part or all of the functions of the control device 500 may be implemented by hardware such as an electronic circuit.

The transport controller 501 controls the operations of the transport mechanisms 640, 670 to transport the substrate W. The temperature controller 502 acquires temperature detection results from the liquid supplier 300 and controls the operation of the liquid supplier 300 such that the ambient-temperature liquid, the cooling liquid, and the heating liquid are respectively maintained at the predetermined temperatures in the ambient-temperature liquid supplier 310, the cooling liquid supplier 320, and the heating liquid supplier 330 of Fig. 2. The control of the liquid supplier 300 by the temperature controller 502 is executed at all times.

The supply controller 503 generates the processing liquid by mixing the base liquid with the chemical liquids, and acquires flow-rate detection results and temperature detection results from the fluid box 100 and controls the operation of the fluid box 100 such that the temperature of the base liquid dynamically changes during the substrate processing. When the process for each substrate W ends, the waste liquid controller 504 controls the operation of the fluid box 100 such that the base liquid remaining in the flow path is led out to the waste liquid device 700 by the mixers 130, 140 of Fig. 4.

The holding controller 505 controls the operation of the processing chamber 200 such that the substrate W is held and rotated by the substrate holder 220 of Fig. 6. The nozzle controller 506 controls the operation of the processing chamber 200 such that the processing nozzle 251 is transported between the processing position and the waiting position by the nozzle transporter 240 of Fig. 6. The discharge controller 507 controls the operation of the processing chamber 200 by switching the open state and the close state of each of the open-close valves 253, 263 such that the processing liquid is discharged from each of the processing nozzles 251, 261 of Fig. 6.

### 7. Substrate Processing

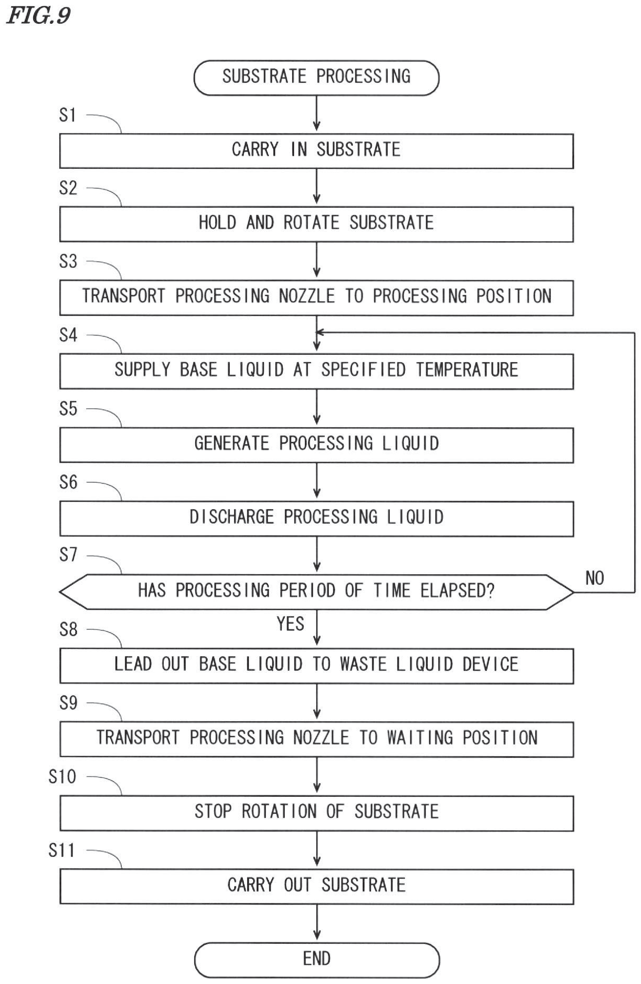

Fig. 9 is a flowchart showing one example of the substrate processing executed in the substrate processing apparatus 600. The substrate processing is executed when the processor 510 of the control device 500 executes the substrate processing program stored in the storage 540 or the like while utilizing the RAM 520 as a work area. The substrate processing will be described below with reference to the substrate processing apparatus 600 of Fig. 1, the fluid box 100 of Fig. 4, the processing chamber 200 of Fig. 6, and the control device 500 of Fig. 8.

During execution of the substrate processing of Fig. 9, the transport controller 501 controls the transport mechanism 640 to transport an unprocessed substrate W from the carrier 630 of any one of the carrier platforms 611 to the receiver-transferer 660. Further, the transport controller 501 controls the transport mechanism 640 to transport a processed substrate W from the receiver-transferer 660 to the carrier 630 of any one of the carrier platforms 611. Further, the temperature controller 502 controls the operations of the temperature adjusters 314, 324, 334 based on temperatures detected by the temperature sensors 313, 323, 333 such that the ambient-temperature liquid, the cooling liquid, and the heating liquid are maintained at the predetermined temperatures.

First, by controlling the transport mechanism 670, the transport controller 501 carries the unprocessed substrate W from the receiver-transferer 660 into the processing chamber 200 in any one of the chambers 650 (step S1). Next, by controlling the substrate holder 220, the holding controller 505 holds and rotates the substrate W (step S2). Further, by controlling the nozzle transporter 240, the nozzle controller 506 transports the processing nozzle 251 from the waiting position to the processing position (step S3). Either the step S2 or the step S3 may be executed first, or the step S2 and the step S3 may be executed at the same time.

Subsequently, the supply controller 503 acquires detection results from the flow-rate sensors and the temperature sensors of the fluid box 100 to control the predetermined open-close valves and the predetermined flow-rate adjustment valves of the fluid box 100, thereby supplying the base liquid at the specified temperature at a current point in time (step S4). Further, by controlling the predetermined open-close valves and the predetermined flow-rate adjustment valves of the fluid box 100, the supply controller 503 mixes the base liquid supplied in the step S4 with the chemical liquids supplied from the liquid supplier 400 to generate the processing liquid (step S5).

Thereafter, by opening the open-close valve 253, 263, the discharge controller 507 discharges the processing liquid from each of the processing nozzles 251, 261 to each of the upper surface and the lower surface of the rotating substrate W (step S6). Thus, the upper surface and the lower surface of the substrate W are processed. Next, the discharge controller 507 determines whether a processing period of time has elapsed (step S7). In a case in which the processing period of time has not elapsed, the discharge controller 507 returns to the step S4. In this case, the processing continues while the temperature of the base liquid changes.

In a case in which the processing period of time has elapsed, the waste liquid controller 504 leads out the base liquid remaining in the flow path from the lead-out ports 134, 144 to the waste liquid device 700 by controlling the mixers 130, 140 (step S8). Further, by controlling the nozzle transporter 240, the nozzle controller 506 transports the processing nozzle 251 from the processing position to the waiting position (step S9). Further, by controlling the substrate holder 220, the holding controller 505 stops the rotation of the substrate W (step S10). Any one of the steps S8 to S10 may be executed first, or the steps S8 to S10 may be executed at the same time.

Thereafter, by controlling the transport mechanism 670, the transport controller 501 carries out the processed substrate from the processing chamber 200 to the receiver-transferer 660 (step S11). Thus, the substrate processing ends.

### 8. Effects

In the substrate processing apparatus 600 according to the present embodiment, the ambient-temperature liquid the temperature of which is adjusted to the first temperature is supplied by the ambient-temperature liquid supplier 310. The cooling liquid the temperature of which is adjusted to the second temperature lower than the first temperature is supplied by the cooling liquid supplier 320. The heating liquid the temperature of which is adjusted to the third temperature higher than the first temperature is supplied by the heating liquid supplier 330. The ambient-temperature liquid supplied by the ambient-temperature liquid supplier 310 or the cooling liquid supplied by the cooling liquid supplier 320 is selectively led out by the switcher 110. The ambient-temperature liquid supplied by the ambient-temperature liquid supplier 310 or the heating liquid supplied by the heating liquid supplier 330 is selectively led out by the switcher 120.

The liquid led out by the switcher 110 and the liquid led out by the switcher 120 are mixed and led out by the mixer 130. The processing liquid including the base liquid led out by the mixer 130 is discharged onto the upper surface of the substrate W by the processing nozzle 251. With this configuration, by adjusting the mixing ratio of the liquids, it is possible to rapidly change the temperature of the base liquid led out by the mixer 130 such that the temperature of the base liquid led out by the mixer 130 is equal to or higher than the second temperature, and is equal to or lower than the third temperature. This enables the temperature of the processing liquid including the base liquid to rapidly change over a wide range. Further, according to the progress of the substrate processing, the upper surface of the substrate W can be processed using the processing liquid the temperature of which dynamically changes.

The substrate processing apparatus 600 further includes the flow-rate adjustment valve 42a that adjusts the flow rate of the liquid led out from the switcher 110 to the mixer 130, and the flow-rate adjustment valve 52b that adjusts the flow rate of the liquid led out from the switcher 120 to the mixer 130. In this case, it is possible to adjust the mixing ratio of the liquids with higher accuracy by respectively adjusting the flow rates of the liquids flowing to the mixer 130 using the flow-rate adjustment valve 42a and the flow-rate adjustment valve 52b. This enables the temperature of the base liquid led out by the mixer 130 to change with higher accuracy.

The substrate processing apparatus 600 further includes the liquid supplier 400 that supplies the chemical liquids, and the mixer 150 that mixes the base liquid led out by the mixer 130 with the chemical liquid supplied by the liquid supplier 400, and leads out the mixed liquid to the processing nozzle 251 as the processing liquid. In this case, the temperature of the processing liquid including the base liquid and the chemical liquids can rapidly change over a wide range. Further, according to the progress of the substrate processing, the upper surface of the substrate W can be cleaned, etched, etc. using the processing liquid which includes the base liquid and the chemical liquids, and the temperature of which dynamically changes.

The mixer 130 includes the lead-out port 133 connected to the flow path leading to the processing nozzle 251, and the lead-out port 134 connected to the flow path leading to the waste liquid device 700, and selectively leads out the base liquid from the lead-out port 133 or the lead-out port 134. With this configuration, even in a case in which the base liquid for the previous substrate processing remains in the flow path leading to the mixer 130, the base liquid can be led out to the waste liquid device 700. This prevents the base liquid remaining in the flow path from being mixed with the base liquid for subsequent substrate processing. As a result, the temperature of the base liquid can accurately change.

The substrate processing apparatus 600 further includes the mixer 140 that mixes the liquid led out by the switcher 110 with the liquid led out by the switcher 120, and the processing nozzle 261 that discharges the processing liquid including the base liquid led out by the mixer 140 to the lower surface of the substrate W. In this case, according to the progress of the substrate processing, the lower surface of the substrate W can be processed using the processing liquid the temperature of which dynamically changes.

The substrate processing apparatus 600 further includes the flow-rate adjustment valve 42a that adjusts the flow rate of the liquid led out from the switcher 110 to the mixer 140, and the flow-rate adjustment valve 52a that adjusts the flow rate of the liquid led out from the switcher 120 to the mixer 140. In this case, it is possible to adjust the mixing ratio of the liquids with higher accuracy by respectively adjusting the flow rates of the liquids flowing to the mixer 140 using the flow-rate adjustment valve 42b and the flow-rate adjustment valve 52a. This enables the temperature of the base liquid led out by the mixer 140 to change with higher accuracy.

The substrate processing apparatus 600 further includes the mixer 160 that mixes the base liquid led out by the mixer 140 with the chemical liquids supplied by the liquid supplier 400, and leads out the mixed liquid to the processing nozzle 261 as the processing liquid. In this case, the temperature of the processing liquid including the base liquid and the chemical liquids can rapidly change over a wide range. Further, according to the progress of the substrate processing, the lower surface of the substrate W can be cleaned, etched, etc. using the processing liquid which includes the base liquid and the chemical liquids, and the temperature of which dynamically changes.

The mixer 140 may have the lead-out port 143 connected to the flow path leading to the processing nozzle 261 and the lead-out port 144 connected to the flow path leading to the waste liquid device 700, and may selectively lead out the base liquid from the lead-out port 143 or the lead-out port 144. With this configuration, even in a case in which the base liquid for the previous substrate processing remains in the flow path leading to the mixer 140, the base liquid can be led out to the waste liquid device 700. This prevents the base liquid remaining in the flow path from being mixed with the base liquid for subsequent substrate processing. As a result, the temperature of the base liquid can accurately change.

The pipe 1 connects the ambient-temperature liquid supplier 310 to the switchers 110, 120. The pipe 2 connects the cooling liquid supplier 320 to the switcher 110. The pipe 3 connects the heating liquid supplier 330 to the switcher 120. The pipe 4 connects the switcher 110 to the mixers 130, 140. The pipe 5 connects the switcher 120 to the mixers 130, 140. The substrate processing apparatus 600 further includes the thermal insulator 10 wound around at least one of the pipes 1 to 5. In this case, heat exchange among the base liquids flowing through different pipes is prevented. This enables the temperature of the base liquid led out by each of the mixers 130, 140 to change with higher accuracy.

### 9. Other Embodiments

(1) While the liquid supplied by the liquid supplier 300 is the pure water in the above-mentioned embodiment, the embodiment is not limited to this. The liquid supplied by the liquid supplier 300 may be functional water or another processing liquid. While the liquid supplied by the liquid supplier 400 is the chemical liquid, the embodiment is not limited to this. The liquid supplied by the liquid supplier 400 may be another processing liquid.
(2) While the liquid supplied by the liquid supplier 300 is used as the base liquid for generating the processing liquid in the above-mentioned embodiment, the embodiment is not limited to this. The liquid supplied by the liquid supplier 300 may be used as a processing liquid for processing the substrate. In this case, the substrate processing apparatus 600 does not have to include the pipes 8, 9, the mixers 150, 160, or the liquid supplier 400.
(3) While the mixer 130 has the lead-out port 134 connected to the waste liquid device 700 in the above-mentioned embodiment, the embodiment is not limited to this. The mixer 130 does not have to have the lead-out port 134. While the mixer 140 similarly has the lead-out port 144 connected to the waste liquid device 700, the embodiment is not limited to this. The mixer 140 does not have to have the lead-out port 144.
(4) While the processing chamber 200 includes both of the processing liquid suppliers 250, 260 in the above-mentioned embodiment, the embodiment is not limited to this. The processing chamber 200 may include one of the processing liquid suppliers 250, 260 and does not have to include the other one of the processing liquid suppliers 250, 260. In a case in which the processing chamber 200 does not include the processing liquid supplier 260, the fluid box 100 does not have to include the mixers 140, 160, and the pipes 4, 5, do not have to respectively have the downstream pipes 4B, 5A. In a case in which the processing chamber 200 does not include the processing liquid supplier 250, the fluid box 100 does not have to include the mixers 130, 150, and the pipes 4, 5, do not have to respectively have the downstream pipes 4A, 5B.
(5) In the above-mentioned embodiment, the flow-rate sensor 41a and the flow-rate adjustment valve 42a are provided in the downstream pipe 4A of the pipe 4, and the flow-rate sensor 41b and the flow-rate adjustment valve 42b are provided in the downstream pipe 4B. However, the embodiment is not limited to this. In a case in which a flow-rate sensor and a flow-rate adjustment valve are provided in the upstream pipe 4C of the pipe 4, the downstream pipe 4A does not have to be provided with either the flow-rate sensor 41a or the flow-rate adjustment valve 42a, and the downstream pipe 4B does not have to be provided with either the flow-rate sensor 41b or the flow-rate adjustment valve 42b.
   Similarly, the flow-rate sensor 51a and the flow-rate adjustment valve 52a are provided in the downstream pipe 5A of the pipe 5, and the flow-rate sensor 51b and the flow-rate adjustment valve 52b are provided in the downstream pipe 5B. However, the embodiment is not limited to this. In a case in which a flow-rate sensor and a flow-rate adjustment valve are provided in the upstream pipe 5C of the pipe 5, the downstream pipe 5A does not have to be provided with either the flow-rate sensor 51a or the flow-rate adjustment valve 52a, and the downstream pipe 5B does not have to be provided with the flow-rate sensor 51b or the flow-rate adjustment valve 52b.
(6) While the substrate processing apparatus 600 includes the flow-rate adjustment valves 42a, 42b, 52a, 52b in the above-mentioned embodiment, the embodiment is not limited to this. In a case in which the mixer 130 is capable of adjusting the mixing ratio of the liquids respectively led in from the switchers 110, 120, the substrate processing apparatus 600 does not have to include the flow-rate adjustment valves 42a, 52b. Similarly, in a case in which the mixer 140 is capable of adjusting the mixing ratio of the liquids respectively led in from the switchers 110, 120, the substrate processing apparatus 600 does not have to include the flow-rate adjustment valves 42b, 52a.
(7) While the thermal insulators 10 are wound around all of the pipes 1 to 5 in the above-mentioned embodiment, the embodiment is not limited to this. The thermal insulator 10 may be wound around only one or some of the pipes 1 to 5. Further, in a case in which heat is not exchanged among liquids flowing through the pipes 1 to 5, the thermal insulators 10 do not have to be wound around the pipes 1 to 5.
(8) While the SC1 or the SC2 is selectively generated as the processing liquid in the above-mentioned embodiment, the embodiment is not limited to this. Only the SC1 or only the SC2 may be generated as the processing liquid. In a case in which only the SC1 is generated as the processing liquid, the liquid supplier 400 does not have to supply hydrochloric acid. In a case in which only the SC2 is generated as the processing liquid, the liquid supplier 400 does not have to supply ammonia water. Further, the processing liquid other than the SC1 and the SC2 may be generated as a processing liquid. In this case, the liquid supplier 400 supplies a chemical liquid corresponding to the type of the processing liquid to be generated.
(10) Although each of the ambient-temperature liquid supplier 310, the cooling liquid supplier 320, and the heating liquid supplier 330 adjusts the temperature of the liquid while circulating the liquid in the above-mentioned embodiment, the embodiment is not limited to this. In a case in which the temperature of the liquid can be maintained at a predetermined temperature with high accuracy, each of the ambient-temperature liquid supplier 310, the cooling liquid supplier 320, and the heating liquid supplier 330 may adjust the temperature of the liquid without circulating the liquid.
(10) While the substrate processing apparatus 600 includes the control device 500 controlling each constituent element in the above-mentioned embodiment, the embodiment is not limited to this. In a case in which each constituent element of the substrate processing apparatus 600 is configured to be controllable by an information processing apparatus outside of the substrate processing apparatus 600, the substrate processing apparatus 600 does not have to include the control device 500.

### 10. Correspondences between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the ambient-temperature liquid supplier 310, the cooling liquid supplier 320, and the heating liquid supplier 330 are respectively examples of first to third liquid suppliers, and the liquid supplier 400 is an example of fourth and fifth liquid suppliers. The switchers 110, 120 are respectively examples of first and second switchers, the mixers 130, 150, 140, 160 are respectively examples of first to fourth mixers, and the processing nozzles 251, 261 are respectively examples of first and second processing nozzles.

The substrate processing apparatus 600 is an example of a substrate processing apparatus, the flow-rate adjustment valves 42a, 52b, 42b, 52a are respectively examples of first to fourth flow-rate adjustment valves, and the pipes 1 to 5 are respectively examples of first to fifth pipes. The thermal insulator 10 is an example of a thermal insulator, the lead-out ports 133, 134, 143, 144 are respectively examples of first to fourth lead-out ports, and the waste liquid device 700 is an example of a waste liquid device.

### 11. Overview of Embodiments

(Item 1) A substrate processing apparatus according to item 1 includes a first liquid supplier that supplies a first liquid a temperature of which is adjusted to a first temperature, a second liquid supplier that supplies the first liquid the temperature of which is adjusted to a second temperature lower than the first temperature, a third liquid supplier that supplies the first liquid the temperature of which is adjusted to a third temperature higher than the first temperature, a first switcher that selectively leads out the first liquid supplied by the first liquid supplier or the first liquid supplied by the second liquid supplier, a second switcher that selectively leads out the first liquid supplied by the first liquid supplier or the first liquid supplied by the third liquid supplier, a first mixer that mixes the first liquid led out by the first switcher and the first liquid led out by the second switcher, and leads out a mixed liquid, and a first processing nozzle that discharges, onto one surface of a substrate, a processing liquid including the first liquid led out by the first mixer.

In this substrate processing apparatus, the first liquid the temperature of which is adjusted to the first temperature is supplied by the first liquid supplier. The first liquid the temperature of which is adjusted to the second temperature lower than the first temperature is supplied by the second liquid supplier. The first liquid the temperature of which is adjusted to the third temperature higher than the first temperature is supplied by the third liquid supplier. The first liquid supplied by the first liquid supplier or the first liquid supplied by the second liquid supplier is selectively led out by the first switcher. The first liquid supplied by the first liquid supplier or the first liquid supplied by the third liquid supplier is selectively led out by the second switcher.

The first liquid led out by the first switcher and the first liquid led out by the second switcher are mixed by the first mixer and led out. The processing liquid including the first liquid led out by the first mixer is discharged onto the one surface of the substrate by the processing nozzle. With this configuration, by adjusting the mixing ratio of the first liquids, it is possible to rapidly change the temperature of the first liquid led out by the first mixer such that the temperature of the first liquid led out by the first mixer is equal to or higher than the second temperature, and equal to or lower than the third temperature. This enables the temperature of the processing liquid including the first liquid to rapidly change over a wide range. Further, according to the progress of the substrate processing, the one surface of the substrate can be processed using the processing liquid the temperature of which dynamically changes.

(Item 2) The substrate processing apparatus according to item 1, may further include a first flow-rate adjustment valve that adjusts a flow rate of the first liquid led out from the first switcher to the first mixer, and a second flow-rate adjustment valve that adjusts a flow rate of the first liquid led out from the second switcher to the first mixer.

In this case, it is possible to adjust the mixing ratio of the first liquids with higher accuracy by respectively adjusting the flow rates of the first liquids flowing to the first mixer using the first flow-rate adjustment valve and the second flow-rate adjustment valve. This enables the temperature of the first liquid led out by the first mixer to change with higher accuracy.

(Item 3) The substrate processing apparatus according to item 1 or 2, may further include a fourth liquid supplier that supplies a second liquid, and a second mixer that mixes the first liquid led out by the first mixer and the second liquid supplied by the fourth liquid supplier, and leads out a mixed liquid to the first processing nozzle as the processing liquid.

In this case, the temperature of the processing liquid including the first liquid and the second liquid can rapidly change over a wide range. Further, according to the progress of the substrate processing, the one surface of the substrate can be processed using the processing liquid the temperature of which dynamically changes and which includes the first liquid and the second liquid.

(Item 4) The substrate processing apparatus according to item 3, wherein the first liquid may be water, and the second liquid may be a chemical liquid.

In this case, the substrate can be cleaned, etched, etc. using the processing liquid.

(Item 5) The substrate processing apparatus according to any one of items 1 to 4, may further include a first pipe that connects the first liquid supplier to the first switcher and the second switcher, a second pipe that connects the second liquid supplier to the first switcher, a third pipe that connects the third liquid supplier to the second switcher, a fourth pipe that connects the first switcher to the first mixer, a fifth pipe that connects the second switcher to the first mixer, and a thermal insulator wound around at least one of the first pipe, the second pipe, the third pipe, the fourth pipe, and the fifth pipe.

In this case, heat exchange among the first liquids flowing through different pipes is prevented. This enables the temperature of the first liquid led out by the first mixer to change with higher accuracy.

(Item 6) The substrate processing apparatus according to any one of items 1 to 5, wherein the first mixer may have a first lead-out port connected to a flow path leading to the first processing nozzle, and a second lead-out port connected to a flow path leading to a waste liquid device, and may selectively lead out the first liquid from the first lead-out port or the second lead-out port.

With this configuration, even in a case in which the first liquid for the previous substrate processing remains in the flow path leading to the first mixer, the first liquid can be led out to the waste liquid device. This prevents the first liquid remaining in the flow path from being mixed with the first liquid for subsequent substrate processing. As a result, the temperature of the first liquid can accurately change.

(Item 7) The substrate processing apparatus according to any one of items 1 to 6, may further include a third mixer that mixes the first liquid led out by the first switcher and the first liquid led out by the second switcher, and a second processing nozzle that discharges, onto another surface of the substrate, the processing liquid including the first liquid led out by the third mixer.

In this case, according to the progress of the substrate processing, the other surface of the substrate can be processed using the processing liquid the temperature of which dynamically changes.

(Item 8) The substrate processing apparatus according to item 7, may further include a third flow-rate adjustment valve that adjusts a flow rate of the first liquid led out from the first switcher to the third mixer, and a fourth flow-rate adjustment valve that adjusts a flow rate of the first liquid led out from the second switcher to the third mixer.

In this case, it is possible to adjust the mixing ratio of the first liquids with higher accuracy by respectively adjusting the flow rates of the first liquids flowing to the third mixer using the third flow-rate adjustment valve and the fourth flow-rate adjustment valve. This enables the temperature of the first liquid led out by the third mixer to change with higher accuracy.

(Item 9) The substrate processing apparatus according to item 7 or 8, may further include a fifth liquid supplier that supplies a second liquid, and a fourth mixer that mixes the first liquid led out by the third mixer and the second liquid supplied by the fifth liquid supplier, and leads out a mixed liquid to the second processing nozzle as the processing liquid.

In this case, the temperature of the processing liquid including the first liquid and the second liquid can rapidly change over a wide range. Further, according to the progress of the substrate processing, the other surface of the substrate can be processed using the processing liquid the temperature of which dynamically changes and which includes the first liquid and the second liquid.

(Item 10) The substrate processing apparatus according to any one of items 7 to 9, wherein the third mixer may have a third lead-out port connected to a flow path leading to the second processing nozzle, and a fourth lead-out port connected to a flow path leading to a waste liquid device, and may selectively lead out the first liquid from the third lead-out port or the fourth lead-out port.

With this configuration, even in a case in which the first liquid for the previous substrate processing remains in the flow path leading to the third mixer, the first liquid can be led out to the waste liquid device. This prevents the first liquid remaining in the flow path from being mixed with the first liquid for subsequent substrate processing. As a result, the temperature of the first liquid can accurately change.

(Item 11) A substrate processing method according to item 11 includes supplying, using a first liquid supplier, a first liquid a temperature of which is adjusted to a first temperature, supplying, using a second liquid supplier, the first liquid the temperature of which is adjusted to a second temperature lower than the first temperature, supplying, using a third liquid supplier, the first liquid the temperature of which is adjusted to a third temperature higher than the first temperature, selectively leading out, using a first switcher, the first liquid supplied by the first liquid supplier or the first liquid supplied by the second liquid supplier, selectively leading out, using a second switcher, the first liquid supplied by the first liquid supplier or the first liquid supplied by the third liquid supplier, mixing the first liquid led out by the first switcher and the first liquid led out by the second switcher, and leading out a mixed liquid, and discharging, using a first processing nozzle, a processing liquid including the first liquid led out by the first mixer onto one surface of a substrate.

With this substrate processing method, by adjusting the mixing ratio of the first liquids, it is possible to rapidly change the temperature of the first liquid led out by the first mixer such that the temperature of the first liquid led out by the first mixer is equal to or higher than the second temperature, and equal to or lower than the third temperature. This enables the temperature of the processing liquid including the first liquid to rapidly change over a wide range. Further, according to the progress of the substrate processing, the one surface of the substrate can be processed using the processing liquid the temperature of which dynamically changes.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A substrate processing apparatus comprising:
a first liquid supplier that supplies a first liquid a temperature of which is adjusted to a first temperature;
a second liquid supplier that supplies the first liquid the temperature of which is adjusted to a second temperature lower than the first temperature;
a third liquid supplier that supplies the first liquid the temperature of which is adjusted to a third temperature higher than the first temperature;
a first switcher that selectively leads out the first liquid supplied by the first liquid supplier or the first liquid supplied by the second liquid supplier;
a second switcher that selectively leads out the first liquid supplied by the first liquid supplier or the first liquid supplied by the third liquid supplier;
a first mixer that mixes the first liquid led out by the first switcher and the first liquid led out by the second switcher, and leads out a mixed liquid; and
a first processing nozzle that discharges, onto one surface of a substrate, a processing liquid including the first liquid led out by the first mixer.

2. The substrate processing apparatus according to claim 1, further comprising:
a first flow-rate adjustment valve that adjusts a flow rate of the first liquid led out from the first switcher to the first mixer; and
a second flow-rate adjustment valve that adjusts a flow rate of the first liquid led out from the second switcher to the first mixer.

3. The substrate processing apparatus according to claim 1 or 2, further comprising:
a fourth liquid supplier that supplies a second liquid; and
a second mixer that mixes the first liquid led out by the first mixer and the second liquid supplied by the fourth liquid supplier, and leads out a mixed liquid to the first processing nozzle as the processing liquid.

4. The substrate processing apparatus according to claim 3, wherein
the first liquid is water, and
the second liquid is a chemical liquid.

5. The substrate processing apparatus according to any one of claims 1 to 4, further comprising:
a first pipe that connects the first liquid supplier to the first switcher and the second switcher;
a second pipe that connects the second liquid supplier to the first switcher;
a third pipe that connects the third liquid supplier to the second switcher;
a fourth pipe that connects the first switcher to the first mixer;
a fifth pipe that connects the second switcher to the first mixer; and
a thermal insulator wound around at least one of the first pipe, the second pipe, the third pipe, the fourth pipe, and the fifth pipe.

6. The substrate processing apparatus according to any one of claims 1 to 5, wherein
the first mixer
has
a first lead-out port connected to a flow path leading to the first processing nozzle, and
a second lead-out port connected to a flow path leading to a waste liquid device, and
selectively leads out the first liquid from the first lead-out port or the second lead-out port.

7. The substrate processing apparatus according to any one of claims 1 to 6, further comprising:
a third mixer that mixes the first liquid led out by the first switcher and the first liquid led out by the second switcher; and
a second processing nozzle that discharges, onto another surface of the substrate, the processing liquid including the first liquid led out by the third mixer.

8. The substrate processing apparatus according to claim 7, further comprising:
a third flow-rate adjustment valve that adjusts a flow rate of the first liquid led out from the first switcher to the third mixer; and
a fourth flow-rate adjustment valve that adjusts a flow rate of the first liquid led out from the second switcher to the third mixer.

9. The substrate processing apparatus according to claim 7 or 8, further comprising:
a fifth liquid supplier that supplies a second liquid; and
a fourth mixer that mixes the first liquid led out by the third mixer and the second liquid supplied by the fifth liquid supplier, and leads out a mixed liquid to the second processing nozzle as the processing liquid.

10. The substrate processing apparatus according to any one of claims 7 to 9, wherein
the third mixer
has
a third lead-out port connected to a flow path leading to the second processing nozzle, and
a fourth lead-out port connected to a flow path leading to a waste liquid device, and
selectively leads out the first liquid from the third lead-out port or the fourth lead-out port.

11. A substrate processing method including:
supplying, using a first liquid supplier, a first liquid a temperature of which is adjusted to a first temperature;
supplying, using a second liquid supplier, the first liquid the temperature of which is adjusted to a second temperature lower than the first temperature;
supplying, using a third liquid supplier, the first liquid the temperature of which is adjusted to a third temperature higher than the first temperature;
selectively leading out, using a first switcher, the first liquid supplied by the first liquid supplier or the first liquid supplied by the second liquid supplier;
selectively leading out, using a second switcher, the first liquid supplied by the first liquid supplier or the first liquid supplied by the third liquid supplier;
mixing the first liquid led out by the first switcher and the first liquid led out by the second switcher, and leading out a mixed liquid; and
discharging, using a first processing nozzle, a processing liquid including the first liquid led out by the first mixer onto one surface of a substrate.
